# EUROPÄISCHE PATENTSCHRIFT

(11) **EP 2 932 811 B1**
(45) Veröffentlichungstag und Bekanntmachung des Hinweises auf die Patenterteilung: **18.09.2019**
(21) Anmeldenummer: 13826920.4
(22) Anmeldetag: 04.11.2013
(51) Int. Cl.: H05K 5/06, H05K 5/02

(54) **ANORDNUNG ZUM DRUCKAUSGLEICH EINES GEHÄUSES**
ARRANGEMENT FOR COMPENSATING PRESSURE IN A HOUSING
ENSEMBLE SERVANT À ÉQUILIBRER LA PRESSION D'UN BOÎTIER

(30) Priorität: 11.12.2012 DE 102012112098
(43) Veröffentlichungstag der Anmeldung: 21.10.2015
(73) Patentinhaber: Conti Temic microelectronic GmbH, 90411 Nürnberg (DE); Honda Motor Co., Ltd., Haga-Machi Haga-Gun Tochigi 321-3393 (JP)
(72) Erfinder: BEER, Stefan, 93164 Laaber (DE); BOBITAN, Radu, R-300721 Timisoara (RO); DRAGOS, Cristian, R-300434 Timisoara (RO); MORIZUMI, Kenji, Utsunomiya-shi Tochigi-ken 321-0904 (JP); IKEDA, Takahiro, Saitama-ken 330-0843 (JP)
(74) Vertreter: Bonn, Roman Klemens
(86) Internationale Anmeldenummer: PCT/DE2013/200269
(87) Internationale Veröffentlichungsnummer: WO 2014/090235

(56) Entgegenhaltungen:
- WO-A1-99/29150
- FR-A1- 2 854 023
- GB-A- 2 330 952

## Beschreibung

Die Erfindung betrifft eine Anordnung zum Druckausgleich eines Gehäuses, wobei zumindest eine Gehäusewandung eine Druckausgleichsöffnung aufweist, welche mit einer semipermeablen Membran verschlossen ist, wobei die Membran zumindest stoffschlüssig an der Gehäusewandung befestigt ist.

Aus der DE 197 08 116 C2 ist eine Anordnung zum Verschließen von Druckausgleichsöffnungen bekannt. Insbesondere sind die Druckausgleichsöffnungen im Gehäuse, beispielsweise eines Kfz-Steuergerätes, eingebracht, wobei die Anordnung zum Verschließen von Druckausgleichsöffnungen aus mindestens zwei Lagen aufgebaut ist. Dabei ist vorgesehen, dass
- die Anordnung auf der Gehäuseoberfläche angebracht wird
- die zweite Lage die Druckausgleichsöffnungen abdeckt und
- aus einem wasserdichten und atmungsaktiven Stoff besteht und
- die erste Lage an den Stellen, an denen der Druckausgleich erfolgt, entfernt ist und die Druckausgleichsöffnungen nur mit der zweiten Lage abgedeckt sind.

Darüber hinaus ist in der DE 10 2006 053 115 A1 ein Gehäuse für eine elektrische Schaltung, insbesondere für ein Steuergerät für ein Fahrzeug beschrieben. Dem Gehäuse ist ein Druckausgleichselement zugeordnet, das eine semipermeable Membran kommunizierend mit dem Inneren des Gehäuses aufweist. Das Gehäuse weist zumindest einen Kunststoffbereich auf, an dem eine Haltevorrichtung für eine Schutzvorrichtung der Membran direkt angeordnet ist.

WO 99/29150 A1 offenbart eine Anordnung zum Druckausgleich eines Gehäuses gemäß dem Oberbegriff des Anspruchs 1.

Der Erfindung liegt die Aufgabe zugrunde, eine gegenüber dem Stand der Technik verbesserte Anordnung zum Druckausgleich eines Gehäuses anzugeben.

Die Aufgabe wird erfindungsgemäß durch die in Anspruch 1 angegebenen Merkmale gelöst.

Vorteilhafte Ausgestaltungen der Erfindung sind Gegenstand der Unteransprüche.

Bei einer Anordnung zum Druckausgleich eines Gehäuses weist zumindest eine Gehäusewandung eine Druckausgleichsöffnung auf, welche mit einer semipermeablen Membran verschlossen ist, wobei die Membran zumindest stoffschlüssig an der Gehäusewandung befestigt ist. Die Gehäusewandung weist im Bereich der Druckausgleichsöffnung eine Einbuchtung und/oder Aussparung zur Aufnahme der Membran auf, deren jeweiliger Umfang mit einem Umfang der Membran korrespondiert und deren Höhe zumindest der Dicke der Membran entspricht.

Durch die Anordnung der Membran in der Einbuchtung und/oder Aussparung ist der umlaufende Rand, insbesondere die umlaufende Stanzkante der Membran in besonders vorteilhafter Weise gegenüber mechanischen Beschädigungen, beispielsweise durch direkte Dampf- und/oder Wasserstrahlbeaufschlagung, geschützt. Die Membran ist im Wesentlichen passgenau in der Einbuchtung und/oder Aussparung angeordnet, durch die stoffschlüssige Befestigung fixiert und somit insbesondere vor einer richtungsgebundenen Strahlbeaufschlagung, beispielsweise bei einer Reinigung des Gehäuses geschützt.

Entspricht die Höhe der Einbuchtung und/oder Aussparung der Dicke der Membran, so ist die Membran flächenbündig in der Einbuchtung und/oder Aussparung angeordnet.

Bei dem Gehäuse kann es sich beispielsweise um Gehäuse für ein Steuergerät eines Fahrzeuges handeln, welches im Nassbereich des Fahrzeuges, beispielsweise im Motorraum, verbaut ist. Die Membran verschließt die Druckausgleichsöffnung des Gehäuses, wobei die Membran angeordnet ist, um die aus Temperatur- und/oder Druckschwankungen auf Dichtungen und/oder Verbindungsstellen des Gehäuses wirkende mechanische und/oder thermische Belastungen auszugleichen. Dazu ist die Membran semipermeabel ausgeführt. So ist die Membran einerseits insbesondere luftdurchlässig, wobei andererseits z. B. Wasser und Schmutz von außen nicht durch die Membran in das Gehäuse eindringen können.

Die angegebene Lösung zum Schutz der Membran, insbesondere zum Schutz ihres Randes vor einem ungewollten Lösen, ist eine vergleichsweise kostengünstige Lösung, wobei durch den Schutz des Randes die Sicherheit für den Betrieb des in dem Gehäuse angeordneten Gerätes erhöht ist. Es ist weitestgehend ausgeschlossen, dass sich die Membran von der Gehäusewandung löst und dadurch die Druckausgleichsöffnung freigegeben ist, so dass z. B. Wasser in das Gehäuse eintritt, das Gehäuse daraufhin von innen korrodiert und/oder das in dem Gehäuse befindliche Gerät beschädigt wird.

In einer bevorzugten Ausführungsform entspricht die Höhe der Einbuchtung und/oder Aussparung mindestens der zweifachen Dicke der Membran, so dass die Membran versenkt in der Einbuchtung und/oder Aussparung angeordnet ist. Somit ist die Membran, insbesondere deren Rand, vor einer richtungsgebundenen Strahlbeaufschlagung geschützt, so dass ein weiter verbesserter Schutz vor einem Ablösen der Membran aufgrund eindringenden Wassers realisiert werden kann.

In vorteilhafter Weise ist die Einbuchtung und/oder Aussparung außen an der Gehäusewandung ausgebildet, so dass die Membran von außen zugänglich ist und sofern die Membran mit einem Wasser beaufschlagt wird, ist weitestgehend ausgeschlossen, dass sich die Membran von der Gehäusewandung löst.

In einer vorteilhaften Ausführungsform ist die Membran selbstklebend ausgebildet, so dass kein Einsatz von Klebstoff zur stoffschlüssigen Befestigung der Membran an der Gehäusewandung erforderlich ist.

Besonders vorteilhaft ist die Membran in zumindest einem umlaufenden Randbereich selbstklebend ausgebildet, wobei der selbstklebende Abschnitt der Membran mit dem Bereich der Einbuchtung und/oder Aussparung korrespondiert, welcher an die Druckausgleichsöffnung anschließt. Dabei ist der selbstklebende Abschnitt der Membran in Abhängigkeit von der Form der Einbuchtung und/oder Aussparung ausgebildet.

Wie oben beschrieben, ist an der mittels der Membran verschlossenen Druckausgleichsöffnung ein Schutzelement angeordnet, welches bevorzugt ein selbstklebender Schutzaufkleber mit Ventilationsöffnungen ist. Ein derart ausgebildetes Schutzelement ist besonders einfach montierbar und stellt einen sicheren Schutz der Membran vor mechanischer Beschädigung sicher.

Erfindungsgemäß weist die Gehäusewandung zur Anordnung des Schutzelementes eine weitere Einbuchtung und/oder Aussparung auf, deren Abmessungen mit den Abmessungen des Schutzelementes korrespondieren. Somit schließt das Schutzelement in Form des Schutzaufklebers flächenbündig mit der Außenseite der Gehäusewandung ab. Die Einbuchtung und/oder Aussparung bildet dabei zum Einen eine Hilfe zur Ausrichtung und zur Befestigung des Schutzaufklebers an der Gehäusewandung. Zum Anderen ist dadurch, dass das Schutzelement ebenfalls in der weiteren Einbuchtung und/oder Aussparung angeordnet ist und der Schutzaufkleber als Schutzelement vorzugsweise flächenbündig mit der Gehäusewandung abschließt, auch der Schutzaufkleber, insbesondere dessen Randbereich, bei einer übermäßigen richtungsgebundenen Strahlbeaufschlagung geschützt, so dass auch hier einem ungewollten Lösen des Schutzaufklebers von der Gehäusewandung entgegen gewirkt ist.

Die Einbuchtung und/oder Aussparung der Membran ist innerhalb der weiteren Einbuchtung und/oder Aussparung des Schutzelementes ausgebildet, so dass das Schutzelement die Membran abdeckt und somit schützt. Dabei ist das Schutzelement ebenfalls von außen an der Gehäusewandung angeordnet und schließt flächenbündig mit dieser ab. Dabei sind die Einbuchtungen und/oder die Aussparungen derart ausgebildet, dass das Schutzelement in Form des Schutzaufklebers ausreichend zu der Membran beabstandet ist, so dass zumindest eine Luftströmung zwischen der Membran und dem Schutzaufkleber realisierbar ist.

Besonders bevorzugt weist die weitere Einbuchtung und/oder Aussparung zumindest eine kanalförmige Vertiefung auf.

In einer weiteren Ausgestaltung ist die zumindest eine Ventilationsöffnung des Schutzaufklebers im an der Gehäusewandung angeordneten Zustand des Schutzaufklebers im Bereich der zumindest einen kanalförmigen Vertiefung angeordnet.

Die zumindest eine Ventilationsöffnung in dem Schutzaufkleber und die zumindest eine kanalförmige Vertiefung in der weiteren Einbuchtung und/oder Aussparung dienen einer gezielten Luftführung, insbesondere bei durch die Membran realisiertem Druckabbau des Gehäuses. Die Luft wird von der Membran mittels der Vertiefung geführt und durch die Ventilationsöffnung kann die Luft in die Umgebung entweichen.

In einer möglichen Ausbildung der Anordnung zum Druckausgleich sind die Einbuchtungen und/oder Aussparungen in die Gehäusewandung geprägt, gestanzt und/oder gefräst. Dadurch ist es möglich, die jeweilige Einbuchtung und/oder Aussparung entsprechend eines eingesetzten Formwerkzeuges auszubilden und zu formen.

Mittels einer derartigen Anordnung zum Druckausgleich ist eine Bauraum optimierte Lösung zur Anordnung und zum Schutz der Membran angegeben.

Ausführungsbeispiele der Erfindung werden im Folgenden anhand von Zeichnungen näher erläutert.

Darin zeigen:
- Figur 1: schematisch eine Schnittdarstellung einer mechanisch umschlossenen Membran zum Druckausgleich eines Gehäuses nach dem Stand der Technik,
- Figur 2: schematisch eine Draufsicht auf eine Membran,
- Figur 3: schematisch eine erste Schnittdarstellung der Membran,
- Figur 4: schematisch eine zweite Schnittdarstellung der Membran,
- Figur 5: schematisch eine Explosionsdarstellung einer Gehäusewandung mit Membran und Schutzelement in einer perspektivischen Ansicht,
- Figur 6: schematisch einen Bereich der Gehäusewandung, in welchem die Membran und das Schutzelement anordbar sind,
- Figur 7: schematisch eine Schnittdarstellung eines Ausschnittes der in dem Bereich angeordneten Membran und des Schutzelementes,
- Figur 8: schematisch den Bereich mit mittels des Schutzelementes abgedeckter Membran und
- Figur 9: schematisch den Bereich mit teilweise abgelöstem Schutzelement.

Einander entsprechende Teile sind in allen Figuren mit den gleichen Bezugszeichen versehen.

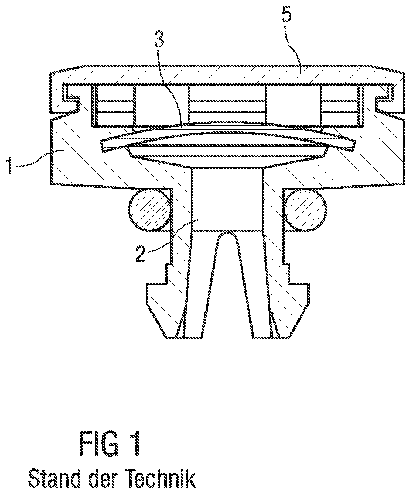

**Figur 1** zeigt eine Schnittdarstellung einer Gehäusewandung 1 eines nicht näher dargestellten Gehäuses mit einer Druckausgleichsöffnung 2, welche nach dem Stand der Technik mit einer Membran 3 verschlossen ist. Die Membran 3 ist mittels eines Schutzelementes 5, das Bestandteil des Gehäuses, insbesondere der Gehäusewandung 1 ist, geschützt. Eine solche vorgefertigte, mechanisch umschlossene und somit geschützte Membran 3 ist verschiedenartig ausführbar und auch als Bauteil vergleichsweise kostenintensiv käuflich erhältlich, wobei ein solches Schutzelement 5 zusätzlichen Bauraum erfordert und Dichtflächen zumindest im Bereich der formschlüssigen Verbindung zwischen der Gehäusewandung 1 und dem Schutzelement 5 entsprechend ausgebildet sein müssen. Bei dieser Ausführungsform ist die Membran 3 formschlüssig in die Gehäusewandung 1 integriert.

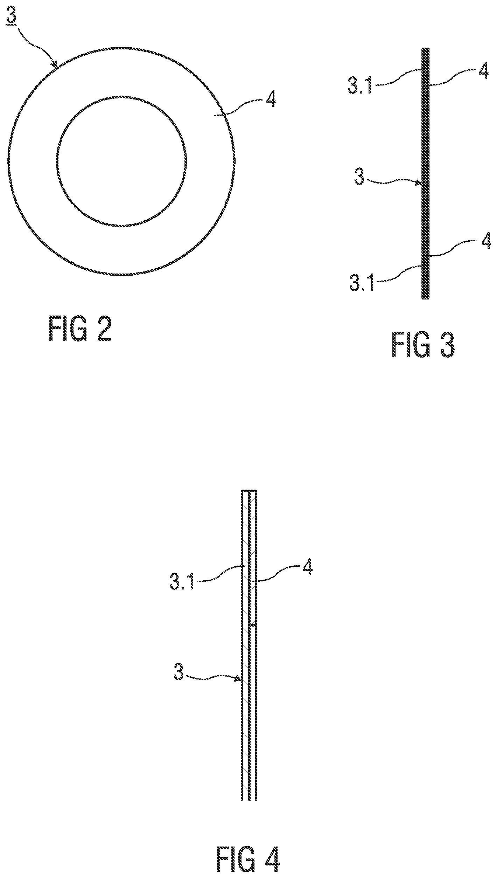

Die **Figuren 2 bis 4** zeigen eine Membran 3 zum Verschließen einer Druckausgleichsöffnung 2 in einer Gehäusewandung 1. Die Membran 3 ist semipermeabel, also halbdurchlässig ausgeführt, so dass insbesondere Luft durch die Membran 3 strömen kann, Feuchtigkeit, beispielsweise in Form von Wasser die Membran 3 jedoch nicht passieren kann. Dabei zeigt **Figur 2** eine Draufsicht, **Figur 3** eine Schnittdarstellung und **Figur** 4 einen Ausschnitt der Schnittdarstellung der Membran 3.

Bei dem Gehäuse, dessen zumindest eine Gehäusewandung 1 die Druckausgleichsöffnung 2 aufweist, handelt es sich insbesondere um ein Gehäuse für ein Steuergerät, welches gegenüber Feuchtigkeit sehr empfindlich ist. Beispielsweise ist das Steuergerät als ein Motorsteuergerät ausgeführt und in einem Motorraum eines Fahrzeuges, d. h. in einem Nassbereich desselben angeordnet. Um im Wesentlichen ausschließen zu können, dass sich das Gehäuse zum Druckausgleich, welcher insbesondere aus Temperaturschwankungen resultiert, verformt und dadurch beschädigt wird und/oder Dichtelemente des Gehäuses in ihrer Funktion versagen, ist die Druckausgleichsöffnung 2 vorgesehen. Über die Druckausgleichsöffnung 2 ist der Druckausgleich vornehmbar, wobei hierbei die Gefahr besteht, dass über die Druckausgleichsöffnung 2 Feuchtigkeit in das Gehäuse eintritt, wodurch die Gefahr von Korrosion und/oder von Beschädigungen des Steuergerätes bestehen kann. Um dieser Gefahr entgegenzuwirken, ist die Druckausgleichsöffnung 2 des Gehäuses mit der semipermeablen Membran 3 verschlossen. Der Druckausgleich kann stattfinden, ohne dass Feuchtigkeit über die Druckausgleichsöffnung 2 in der Gehäusewandung 1 in das Gehäuse eindringen kann.

Die Membran 3 ist kreisförmig ausgebildet und selbstklebend ausgeführt, so dass es zur Befestigung der Membran 3 an der Gehäusewandung 1 zum Verschließen der Druckausgleichsöffnung 2 keiner weiteren Hilfsmittel bedarf. Im Vergleich zu der in **Figur 1** gezeigten Membran 3 ist die selbstklebende Membran 3 vergleichsweise kostengünstig. Dabei besteht die selbstklebende Membran 3 aus der Membran 3 selbst und einer an dieser befestigten doppelseitig klebenden Folie 4, wodurch die Membran 3 als selbstklebend ausgeführt ist.

Der Bereich, in dem die Membran 3 mittels der Folie 4 selbstklebend ausgebildet ist, erstreckt sich ringförmig über einen Randbereich 3.1 der Membran 3, wie die **Figuren 3 und 4** im Detail zeigen.

Die Membran 3 und die klebende Folie 4 werden üblicherweise in einem Arbeitsgang aus einem Trägermaterial ausgestanzt oder ausgeschnitten und zumeist auf eine Rolle aufgewickelt. Mittels einer derartigen Anlieferform ist eine hochautomatisierte Montage zur Anordnung der Membran 3 in einer Produktionsumgebung möglich.

Einen wesentlichen Nachteil der selbstklebenden Membran 3, welche außen an der Gehäusewandung 1 befestigbar ist, stellt insbesondere die Tatsache dar, dass die Membran 3 nicht vor mechanischer Beschädigung und/oder durch Feuchtigkeit, beispielsweise durch einen Dampf- und/oder Wasserstrahl geschützt ist.

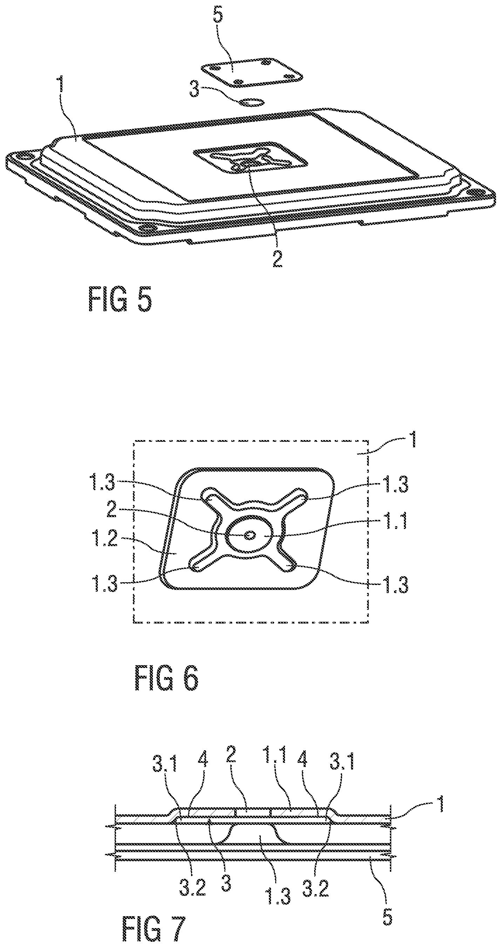

In **Figur5** ist eine perspektivische Ansicht einer Explosionsdarstellung einer Gehäusewandung 1 mit Druckausgleichsöffnung 2, einer Membran 3 und eines Schutzelementes 5 in Form eines Schutzaufklebers dargestellt.

Zum Schutz der Membran 3 vor mechanischer Beschädigung und/oder vor Feuchtigkeit ist das Schutzelement 5 vorgesehen, welches über der Membran 3 zu dieser beabstandet an der Gehäusewandung 1 anordbar ist. Insbesondere wird der Schutzaufkleber als Schutzelement 5 an die Gehäusewandung 1 geklebt. Das Schutzelement 5 in Form des Schutzaufklebers vermindert einerseits das Risiko der mechanischen Beschädigung der Membran 3 und andererseits wird die Membran 3 vor einer direkten richtungsgebundenen Strahlbeaufschlagung aufgrund der Verringerung des hydraulischen Druckes mittels des Schutzelementes 5 geschützt. Beispielsweise wird das Gehäuse zur Reinigung mit einem richtungsgebundenen Strahl beaufschlagt.

Die Anordnung und die Ausbildung des Schutzelementes 5 in Form des Schutzaufklebers werden in den **Figuren 7****,** **8 und 9** näher erläutert.

**Figur 6** zeigt einen vergrößerten Ausschnitt des Bereiches der Gehäusewandung 1, in dem die Druckausgleichsöffnung 2 ausgebildet ist.

Die Gehäusewandung 1 weist eine Einbuchtung und/oder Aussparung 1.1 auf, in deren Mitte sich die Druckausgleichsöffnung 2 befindet. Die Einbuchtung und/oder Aussparung 1.1 weist eine Kreisform auf, wobei in der Einbuchtung und/oder Aussparung 1.1 der Gehäusewandung 1 die Membran 3 anordbar ist. Dabei ist die Einbuchtung und/oder Aussparung 1.1 von außen in die Gehäusewandung 1 eingebracht, so dass die mittels der Einbuchtung und/oder Aussparung 1.1 gebildete Vertiefung in Richtung eines Gehäuseinneren gerichtet ausgebildet ist.

Beispielsweise ist die Einbuchtung und/oder Aussparung 1.1 mittels Prägens, Stanzens und/oder Fräsens und/oder eines anderen geeigneten Umformverfahrens in die Gehäusewandung 1 eingebracht.

In der Einbuchtung und/oder Aussparung 1.1 ist die Membran 3 anordbar, wobei die Membran 3 hinsichtlich ihres Umfanges Abmessungen entsprechend der Abmessungen des Umfanges der Einbuchtung und/oder Aussparung 1.1 oder umgekehrt aufweist. Die Einbuchtung und/oder Aussparung 1.1 ist zur Anordnung der Membran 3 zum Verschließen der Druckausgleichsöffnung 2 vorgesehen, wobei die Einbuchtung und/oder Aussparung 1.1 eine Tiefe aufweist, die mindestens der Dicke bevorzugt der zweifachen Dicke der Membran 3 entspricht. Dadurch ist die Membran 3 vollständig in der Einbuchtung und/oder Aussparung 1.1 angeordnet, wie in der Schnittdarstellung in **Figur 7** näher gezeigt ist. Entspricht die Tiefe der Einbuchtung und/oder Aussparung 1.1 lediglich der Dicke der Membran 3, schließt die Membran 3 im angeordneten Zustand flächenbündig mit der Gehäusewandung 1 ab. Besonders bevorzugt sind die Einbuchtung und/oder Aussparung 1.1 und die Membran 3 derart ausgebildet, dass die Membran 3 formschlüssig in der Einbuchtung und/oder Aussparung 1.1 anordbar und stoffschlüssig befestigbar ist.

Da die Membran 3 in der Einbuchtung und/oder Aussparung 1.1 angeordnet ist, ist ein Rand 3.2, d. h. eine Kante, insbesondere eine Stanzkante, der Membran 3 nicht frei zugänglich sondern geschützt in der Einbuchtung und/oder Aussparung 1.1 angeordnet. Somit ist eine Beschädigung der Membran 3 aufgrund einer richtungsgebundenen Strahlbeaufschlagung, beispielsweise mittels Dampf und/oder Wasser weitestgehend ausschließbar.

Darüber hinaus weist die Gehäusewandung 1 zur Anordnung des Schutzaufklebers als Schutzelement 5 eine weitere Einbuchtung und/oder Aussparung 1.2 auf, innerhalb welcher die Einbuchtung und/oder Aussparung 1.1 der Membran 3 angeordnet ist.

Die weitere Einbuchtung und/oder Aussparung 1.2 weist äußere Abmessungen auf, die mit Abmessungen des Schutzelementes 5, insbesondere mit dessen Außenkontur korrespondieren. Zudem umfasst die weitere Einbuchtung und/oder Aussparung 1.2 vier kanalförmige Vertiefungen 1.3, die im Wesentlichen kreuzförmig um die Einbuchtung und/oder Aussparung 1.1 der Membran 3 angeordnet und ausgebildet sind. Dabei ist mittels der Tiefe der kanalförmigen Vertiefungen 1.3 ein Abstand zwischen dem Schutzelement 5 in Form des Schutzaufklebers und der Membran 3 einstellbar, sofern die Tiefe der Einbuchtung und/oder Aussparung 1.1 der Membran 3 lediglich der Dicke derselben entspricht. Dabei ist ein Abstand des Schutzelementes 5 zu der Membran 3 weitestgehend frei wählbar.

Wie oben beschrieben ist in **Figur 7** ein Ausschnitt einer Schnittdarstellung des Bereiches der Druckausgleichsöffnung 2 in der Gehäusewandung 1 mit befestigter Membran 3 und befestigtem Schutzelement 5 dargestellt. In dem vorliegenden Ausführungsbeispiel gemäß **Figur 7** entspricht die Tiefe der Einbuchtung und/oder Aussparung 1.1 der Dicke der Membran 3, so dass die Membran 3 flächenbündig mit der Gehäusewandung 1 im Bereich der kanalförmigen Vertiefungen 1.3 abschließt.

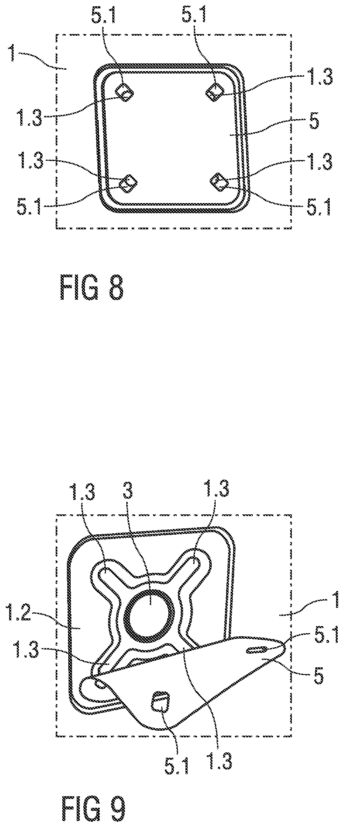

Das Schutzelement 5 weist in seinen Eckbereichen jeweils eine Ventilationsöffnung 5.1 auf, wie in **Figur 8 und 9** näher gezeigt ist. Dabei ist die jeweilige Ventilationsöffnung 5.1 bei an der Gehäusewandung 1 befestigtem Schutzelement 5 im Bereich einer kanalförmigen Vertiefung 1.3 der weiteren Einbuchtung und/oder Aussparung 1.1 angeordnet. Eine jeweilige kanalförmige Vertiefung 1.3 ist also strömungstechnisch mit einer Ventilationsöffnung 5.1 des Schutzelementes 5, d. h. des Schutzaufklebers verbunden, so dass insbesondere aus dem Gehäuse über die Membran 3 entweichende Luft mittels der kanalförmigen Vertiefungen 1.3 zu den Ventilationsöffnungen 5.1 geführt und durch diese in die Umgebung des Gehäuses strömen kann.

**Figur 8** zeigt das in der weiteren Einbuchtung und/oder Aussparung 1.2 angeordnete Schutzelement 5 in Form des Schutzaufklebers, wobei in **Figur 9** das Schutzelement 5 im teilweise von der Gehäusewandung 1 abgelösten Zustand dargestellt ist. Zudem verschließt die Membran 3 die Druckausgleichsöffnung 2.

Eine Form der Ventilationsöffnungen 5.1 und des Schutzelementes 5 ist weitestgehend frei wählbar, wobei diese bevorzugt in einem vorgegebenen Abstand zu der Membran 3 angeordnet bzw. ausgebildet sind.

Durch die Ventilationsöffnungen 5.1 besteht die Gefahr, dass durch einen richtungsgebundenen Strahl von beispielsweise Dampf und/oder Wasser zwischen Schutzelement 5 und Membran 3 gelangt, wobei durch die formschlüssige Anordnung der Membran 3 in der Einbuchtung und/oder Aussparung 1.1 ein Eindringen von Feuchtigkeit weitestgehend ausgeschlossen ist und somit das Risiko eines Ablösens der Membran 3 von der Folie 4 und dadurch ein Freigeben der Druckausgleichsöffnung 2 zumindest verringert ist.

### BEZUGSZEICHENLISTE

- 1: Gehäusewandung
- 1.1: Einbuchtung/Aussparung
- 1.2: weitere Einbuchtung/Aussparung
- 1.3: kanalförmige Vertiefung
- 2: Druckausgleichsöffnung
- 3: Membran
- 3.1: Randbereich
- 3.2: Rand
- 4: Folie
- 5: Schutzelement
- 5.1: Ventilationsöffnung

## Patentansprüche

1. Anordnung zum Druckausgleich eines Gehäuses, wobei zumindest eine Gehäusewandung (1) eine Druckausgleichsöffnung (2) aufweist, welche mit einer semipermeablen Membran (3) verschlossen ist, wobei die Membran (3) zumindest stoffschlüssig an der Gehäusewandung (1) befestigt und mittels eines Schutzelementes (5) abgedeckt ist, wobei
die Gehäusewandung (1) im Bereich der Druckausgleichsöffnung (2) eine Einbuchtung und/oder Aussparung (1.1) zur Aufnahme der Membran (3) aufweist, deren jeweiliger Umfang mit einem Umfang der Membran (3) korrespondiert und deren Höhe zumindest der Dicke der Membran (3) entspricht, **dadurch gekennzeichnet, dass**
dass die Gehäusewandung (1) zur Anordnung des Schutzelementes (5) eine weitere Einbuchtung und/oder Aussparung (1.2) aufweist, deren Abmessungen mit den Abmessungen des Schutzelementes (5) korrespondiert, und dass die Einbuchtung und/oder Aussparung (1.1) der Membran (3) innerhalb der weiteren Einbuchtung und/oder Aussparung (1.2) des Schutzelementes (5) ausgebildet ist.

2. Anordnung nach Anspruch 1,
**dadurch gekennzeichnet, dass** die Höhe der Einbuchtung und/oder Aussparung (1.1) mindestens der zweifachen Dicke der Membran (3) entspricht.

3. Anordnung nach Anspruch 1 oder 2,
**dadurch gekennzeichnet, dass** die Einbuchtung und/oder Aussparung (1.1) zur Aufnahme der Membran (3) an einer Außenseite der Gehäusewandung (1) ausgebildet ist.

4. Anordnung nach einem der vorhergehenden Ansprüche,
**dadurch gekennzeichnet, dass** die Membran (3) zumindest in einem umlaufenden Randbereich (3.1) selbstklebend ausgebildet ist.

5. Anordnung nach einem der vorhergehenden Ansprüche,
**dadurch gekennzeichnet, dass** das Schutzelement (5) ein selbstklebender Schutzaufkleber ist, welcher zumindest eine Ventilationsöffnung (5.1) aufweist.

6. Anordnung nach Anspruch 5 oder 6 ,
**dadurch gekennzeichnet, dass** die weitere Einbuchtung und/oder Aussparung (1.2) zumindest eine kanalförmige Vertiefung (1.3) aufweist.

7. Anordnung nach Anspruch 6 ,
**dadurch gekennzeichnet, dass** die zumindest eine Ventilationsöffnung (5.1) des Schutzaufklebers im an der Gehäusewandung (1) angeordneten Zustand des Schutzaufklebers im Bereich der zumindest einen kanalförmigen Vertiefung (1.3) angeordnet ist.

8. Anordnung nach Anspruch 6 oder 7 ,
**dadurch gekennzeichnet, dass** die Einbuchtungen und/oder Aussparungen (1.1, 1.2) und/oder die kanalförmigen Vertiefungen (1.3) in die Gehäusewandung (1) geprägt, gestanzt und/oder gefräst sind bzw. ist.

## Claims

1. Arrangement for compensating pressure in a housing, wherein at least one housing wall (1) has a pressure compensation opening (2), which is closed with a semipermeable membrane (3), wherein the membrane (3) is fixed, at least in a materially bonded way, on the housing wall (1) and is covered by means of a protective element (5), wherein
the housing wall (1) has, in the region of the pressure compensation opening (2), an indentation and/or recess (1.1) for receiving the membrane (3), the respective circumference thereof corresponding to a circumference of the membrane (3) and the height thereof corresponding at least to the thickness of the membrane (3), **characterized in that**
the housing wall (1) has a further indentation and/or recess (1.2) for the arrangement of the protective element (5), the dimensions of said indentation or recess corresponding to the dimensions of the protective element (5),
and the indentation and/or recess (1.1) for the membrane (3) is formed within the further indentation and/or recess (1.2) for the protective element (5).

2. Arrangement according to Claim 1,
**characterized in that** the height of the indentation and/or recess (1.1) corresponds to at least twice the thickness of the membrane (3).

3. Arrangement according to Claim 1 or 2,
**characterized in that** the indentation and/or recess (1.1) for receiving the membrane (3) is formed on an outer side of the housing wall (1).

4. Arrangement according to one of the preceding claims,
**characterized in that** the membrane (3) is designed to be self-adhesive, at least in a peripheral rim region (3.1).

5. Arrangement according to one of the preceding claims,
**characterized in that** the protective element (5) is a self-adhesive protective sticker, which has at least one ventilation opening (5.1).

6. Arrangement according to Claim 5 or 6,
**characterized in that** the further indentation and/or recess (1.2) has at least one channel-shaped depression (1.3).

7. Arrangement according to Claim 6,
**characterized in that** the at least one ventilation opening (5.1) in the protective sticker is arranged in the region of the at least one channel-shaped depression (1.3) in the state of the protective sticker in which it is arranged on the housing wall (1).

8. Arrangement according to Claim 6 or 7,
**characterized in that** the indentations and/or recesses (1.1, 1.2) and/or the channel-shaped depressions (1.3) are stamped, punched and/or milled into the housing wall (1).

## Revendications

1. Ensemble servant à équilibrer la pression d'un boîtier, dans lequel au moins une paroi de boîtier (1) présente une ouverture d'équilibrage de pression (2) qui est fermée par une membrane semi-perméable (3), dans lequel la membrane (3) est fixée au moins par complémentarité de matériau à la paroi de boîtier (1) et recouverte au moyen d'un élément protecteur (5), dans lequel la paroi de boîtier (1) présente, dans la zone de l'ouverture d'équilibrage de pression (2), un creux et/ou un évidement (1.1) qui sert à recevoir la membrane (3) et dont la circonférence respective correspond à une circonférence de la membrane (3) et dont la hauteur correspond au moins à l'épaisseur de la membrane (3),
**caractérisé en ce que**, pour la mise en place de l'élément protecteur (5), la paroi de boîtier (1) présente un autre creux et/ou évidement (1.2) dont les dimensions correspondent aux dimensions de l'élément protecteur (5), et **en ce que** le creux et/ou l'évidement (1.1) de la membrane (3) est réalisé à l'intérieur de l'autre creux et/ou évidement (1.2) de l'élément protecteur (5).

2. Ensemble selon la revendication 1,
**caractérisé en ce que** la hauteur du creux et/ou de l'évidement (1.1) correspond au moins au double de l'épaisseur de la membrane (3).

3. Ensemble selon la revendication 1 ou 2,
**caractérisé en ce que** le creux et/ou l'évidement (1.1) est réalisé sur une face extérieure de la paroi (1) du boîtier pour recevoir la membrane (3).

4. Ensemble selon l'une des revendications précédentes,
**caractérisé en ce que** la membrane (3) est réalisée sous une forme auto-adhésive au moins dans une zone de bord circonférentielle (3.1).

5. Ensemble selon l'une des revendications précédentes,
**caractérisé en ce que** l'élément protecteur (5) est un adhésif protecteur auto-adhésif qui présente au moins une ouverture d'aération (5.1).

6. Ensemble selon la revendication ou 6, **caractérisé en ce que** l'autre creux et/ou évidement (1.2) présente au moins un renfoncement en forme de canal (1.3).

7. Ensemble selon la revendication 6,
**caractérisé en ce que** ladite au moins une ouverture d'aération (5.1) de l'adhésif protecteur est disposée dans la zone dudit au moins un renfoncement en forme de canal (1.3) dans un état dans lequel l'adhésif protecteur est disposé sur la paroi de boîtier (1).

8. Ensemble selon la revendication 6 ou 7,
**caractérisé en ce que** les creux et/ou les évidements (1.1, 1.2) et/ou les renfoncements en forme de canal (1.3) sont estampés, percés et/ou fraisés dans la paroi de boîtier (1).
